Europäisches Patentamt

European Patent Office

Office européen des brevets

(19)

(11) Veröffentlichungsnummer: **0 028 306**
**B1**

(12) **EUROPÄISCHE PATENTSCHRIFT**

(45) Veröffentlichungstag der Patentschrift:
18.05.83

(21) Anmeldenummer: 80105501.3

(22) Anmeldetag: 15.09.80

(51) Int. Cl.³: **G 11 C 11/40**, G 11 C 8/00,
H 01 L 27/02, H 01 L 27/06,
G 11 C 5/06

(54) Monolithisch integrierte Speicheranordnung mit I2L-Speicherzellen.

(30) Priorität: 02.11.79 DE 2944141

(43) Veröffentlichungstag der Anmeldung:
13.05.81 Patentblatt 81/19

(45) Bekanntmachung des Hinweises auf die Patenterteilung:
18.05.83 Patentblatt 83/20

(84) Benannte Vertragsstaaten:
DE FR GB

(73) Patentinhaber: International Business Machines
Corporation, Armonk, N.Y. 10504 (US)

(72) Erfinder: Wiedmann, Siegfried, Dr., Im Himmel 64A,
D-7000 Stuttgart 80 (DE)
Erfinder: Berger, Horst, Dr., Eltinger Strasse 2,
D-7032 Sindelfingen (DE)

(74) Vertreter: Gaugel, Heinz, Dipl.-Ing., Schönaicher
Strasse 220, D-7030 Böblingen (DE)

(56) Entgegenhaltungen:

EP-A-0 004 871
EP-A-0 005 601
EP-A-0 006 702
EP-A-0 006 753
EP-A-0 011 405
US-A-3 531 778
US-A-4 021 786
US-A-4 032 902
US-A-4 112 511
US-A-4 158 237
US-A-4 193 126

IEEE TRANSACTIONS ON ELECTRON DEVICES, Band
ED-26, Nr. 6, Juni 1979, Seiten 886-892 New York,
U.S.A. K. KAWARADA et al.: «A 4K-bit static 12L memory» * Seiten 888-889, Abschnitt C. «Cell-Array Con-

(56) Entgegenhaltungen:

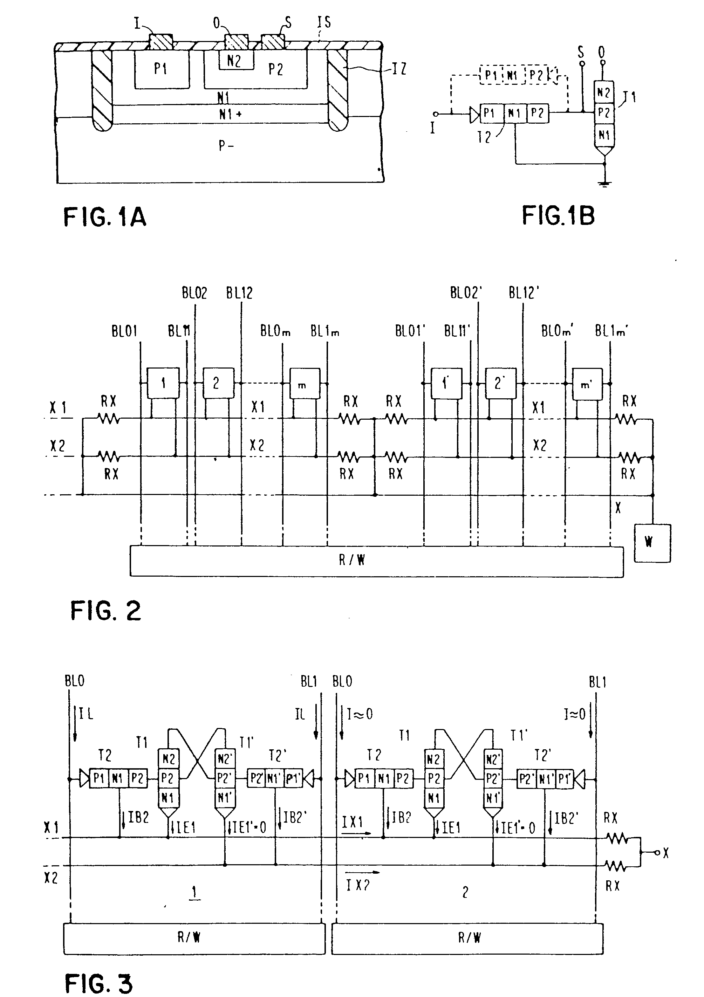

struction»; Figuren 2, 4, 5 *
IEEE INTERNATIONAL SOLID-STATE CIRCUITS CONFE-
RENCE, 15. Februar 1980, Seiten 222-223, 276 New
York, U.S.A. S.K. WIEDMANN et al.: «A 16Kb static
MTL/12L memory chip»
IBM TECHNICAL DISCLOSURE BULLETIN, Band 21, Nr.
1, Juni 1978, Seiten 231-232 Armonk, U.S.A. S.K.
WIEDMANN: «MTL storage cell»
IBM TECHNICAL DISCLOSURE BULLETIN, Band 22, Nr.
2, Juli 1979, Seiten 617-618 Armonk, U.S.A. R. REMS-
HARDT et al.: «Active injection memory cell»
IEEE JOURNAL OF SOLID-STATE CIRCUITS, Band SC-5,
Nr. 5, Oktober 1970, Seiten 196-202 New York, U.S.A.
J.C. BARRETT et al.: «Design considerations for a highspeed bipolar READ-ONLY memory» * Figur 5 *

Monolithisch integrierte Speicheranordnung mit I2L-Speicherzellen

Die Erfindung betrifft eine monolithisch integrierte Speicheranordnung mit in einer Matrix angeordneten Speicherzellen aus jeweils zwei jeweils einen Injektor und zugeordneten invertierenden Transistor umfassenden I²L-Strukturen, die durch eine Kreuzkopplung zwischen jeweils dem Kollektor des einen und der Basis des anderen invertierenden Transistors zu einem Flipflop verbunden sind, wobei die Zufuhr des Betriebsstromes und der Schreib-/Leseströme der Speicherzellen einer Matrixspalte über ein an die Injektoren dieser Speicherzellen angeschlossenes Bitleitungspaar und die Selektion der Speicherzelle einer Matrixzeile über eine mit den invertierenden Transistoren dieser Speicherzellen gekoppelte, gemeinsame Adressleitung erfolgt.

Auf dem Gebiet der logischen Verknüpfungsschaltungen mit Bipolartransistoren hat in den letzten Jahren eine bemerkenswerte Weiterentwicklung stattgefunden, die in der Fachwelt grosse Aufmerksamkeit auf sich gezogen hat und unter der Bezeichnung MTL (Merged Transistor Logic) oder auch I²L (Integrated Injection Logic) breiten Eingang in die Fachliteratur gefunden hat. Es wird beispielsweise auf die Aufsätze im IEEE Journal of Solid-State Circuits, Vol. ST-7, Nr. 5, Oktober 1972, Seiten 340 ff. und 346 ff. verwiesen. Als zugehörige Patentliteratur seien beispielsweise die US-Patentschriften 3 736 477 und 3 816 758 genannt. Dieses Injektions-Logikkonzept beruht im wesentlichen auf invertierenden Ein- oder Mehrfachkollektortransistoren, die durch Injektion von Minoritätsladungsträgern in die Nähe (Grössenordnung einer Diffusionlänge) ihrer Emitter-Basis-Übergänge gespeist werden.

Eine Grundstruktur dieses Logikkonzeptes, wie es in den genannten US-Patentschriften dargelegt wird, besteht darin, dass in einer Halbleiterschicht eines ersten Leitungstyps in einem Abstand als Emitter- und Kollektorzonen einer lateralen Transistorstruktur dienende Zonen des zweiten Leitungstyps angeordnet sind und dass in der Kollektorzone der lateralen Transistorstruktur mindestens eine weitere Zone des dazu entgegengesetzten Leitungstyps als Kollektorzone einer invers betriebenen vertikalen, komplementären Transistorstruktur angeordnet ist. Die Kollektorzone der lateralen Transistorstruktur bildet gleichzeitig die Basiszone der vertikalen Transistorstruktur. Die Basiszone der lateralen und die Emitterzone der invers betriebenen vertikalen Transistorstruktur werden durch die Halbleiterschicht des ersten Leitungstyps gebildet. Zum Betrieb dieser Halbleiterstruktur als logische Grundschaltung wird ein Strom in die Emitterzone der lateralen Transistorstruktur eingeprägt, der in Abhängigkeit von dem an der Kollektorzone des lateralen bzw. der Basiszone des vertikalen Transistors angelegten Eingangssignal den das invertierte Ausgangssignal liefernden Strom durch die vertikale Transistorstruktur steuert. Durch die Zusammenlegung der gleichdotierten und auf gleichem Potential liegenden Zonen der beiden Transistoren erhält man eine optimal integrierte Struktur, deren Herstellung im betrachteten Ausführungsbeispiel nur zwei Diffusionsprozesse erforderlich macht.

Andere bekannte Ausführungsformen dieser Grundschaltung bestehen aus einer Schichtstruktur mit vier Zonen unterschiedlichen Leitungstyps, die zwei vertikale, miteinander monolithisch vereinte Transistorstrukturen umfassen und in entsprechender Weise betrieben werden. Dabei erfolgt wiederum über die Emitterzone des einen Transistors die Injektion von Minoritätsladungsträgern, was die Stromversorgung der Grundschaltung bewirkt, während über die andere Transistorstruktur das Ausgangssignal geliefert wird.

Die beschriebenen invertierenden, logischen Grundschaltungen sind nicht nur in hervorragender Weise zum Aufbau von logischen Verknüpfungsschaltungen geeignet, sie sind insbesondere in vorteilhafter Weise als Baustein für monolithisch integrierte Speicherzellen einsetzbar. Derartige Speicherzellen finden vor allem Anwendung in digitalen Datenverarbeitungsanlagen. Die Speicherzellen sind in einer Matrix angeordnet, so dass über entsprechende Selektionseinrichtungen jede einzelne Zelle adressiert und dabei Daten in sie eingeschrieben oder aus ihr ausgelesen werden können.

Es ist bekannt, dass bei invertierenden logischen Schaltungen jeweils zwei Stufen erforderlich sind, um den Kern einer Speicherzelle nach Art von bistabilen Kippstufen bzw. Flipflops zu erhalten. Eine Speicherzelle kann also aus zwei derartigen Grundschaltungen aufgebaut werden, die symmetrisch ausgebildet sind und bei denen jeweils der Ausgang der einen mit dem Eingang der anderen Schaltung zur Erfüllung der Kopplungsbedingung verbunden ist. Auf diese Weise entsteht die erforderlich Kreuzkopplung, wie sie bei den üblichen Flipflops vorhanden ist.

Aus der DE-OS 2 307 739 ist teils eine Speicherzelle bekannt, die aus zwei der beschriebenen logischen Grundschaltungen zusammengesetzt ist und bei der der Kollektor des invertierenden Transistors der einen Grundschaltung jeweils mit der Basis des invertierenden Transistors der anderen Grundschaltung gekoppelt ist. Die beiden invertierenden Transistoren werden invers betrieben und bilden die eigentlichen Flipflop-Transistoren. Als Lastelemente für beide Flipflop-Transistoren dienen die jeweils über eine gesonderte Leitung angeschlossenen komplementären Transistoren der beiden Grundschaltungen, über die die Injektion der Minoritätsladungsträger, also die Stromversorgung erfolgt. Zum Zwecke der Adressierung, also zum Einschreiben und Auslesen der Speicherzelle, ist zusätzlich die Basis jedes Flipflop-Transistors mit dem Emitter eines zugeordneten zusätzlichen, ebenfalls komplementären Adressier-Transistor verbunden, dessen Kollektor an der zugeordneten Bitleitung und dessen Basis an der Adressleitung liegt. Ausser dem das Lastelement bildenden, injizierenden Transistor ist also zusätzlich ein Adressier-Transistor erforderlich, der wiederum durch eine laterale Transistorstruktur gebildet wird.

Ausgehend von der bekannten invertierenden logischen Grundschaltung ist in der DE-OS 2 612 666 bereits eine verbesserte Grundschaltung angegeben, die insbesondere aufgrund ihrer gewählten Betriebsweise bei der Bildung logischer Verknüpfungsschaltungen beträchtliche Vorteile bietet, wobei eine Belastung des eigentlichen Signalweges durch notwendige Abfühlschaltungen weitgehend vermieden wird. Dies wird dadurch erreicht, dass bei der als "Integrated Injection Logic" ($I^2L$) bekannten Grundschaltung der Leitzustand des invertierenden Transistors mit Hilfe einer in den Injektionsstromkreises, also den Betriebsstromkreis, eingefügten Abfühlschaltung abgefühlt wird. Diese Abfühlung erfolgt aufgrund des bei leitendem invertierenden Transistors in das Injektionsgebiet rückinjizierten Stromes. Der in der genannten Offenlegungsschrift ebenfalls beschriebenen Anwendung dieses Prinzips in einer aus zwei derartigen, nach Art eines Flipflops zu einer Speicherzelle zusammengesetzten Schaltungen wird sowohl die Betriebsstromzuführung als auch die Kopplung der Schreib-/Lesesignale über an die Injektionszone angeschlossene Bitleitungen vorgenommen. Auf diese Weise werden keine gesonderten Adressier-Transistoren benötigt und die hierfür bei der bekannten Speicherzelle erforderliche zusätzliche Injektionszone kann entfallen.

Bei der Verwirklichung der in der genannten Offenlegungsschrift beschriebenen $I^2L$-Grundschaltung und der damit aufgebauten Speicherzelle ergeben sich gewisse Probleme dann, wenn auf minimale Abmessungen der Struktur, also auf maximale Integrationsdichte Wert gelegt wird. Diese Minimalabmessungen, d.h. der minimal erreichbare Flächenbedarf je $I^2L$-Grundschaltung sind im wesentlichen durch die technologisch bedingten Grenzen der kleinsten erreichbaren Abmessungen der Kontaktöffnungen und Diffusionsfenster in den bei der Herstellung angewandten lithographischen Prozessen zwangsläufig festgelegt.

Eine unter Einhaltung dieser durch die angewandte Technologie festgelegten, auf minimalen Flächenbedarf ausgerichteten Bemessungsregeln aufgebaute $I^2L$-Struktur weist die Eigenschaft auf, dass die sich gegenüberliegenden injizierenden und rückinjizierenden Kanten des lateralen Transistors die geringstmögliche Länge aufweisen. Diese Kantenlänge ist aber ausschlaggebend für den Wirkungsgrad der Injektion und der Rückinjektion von Minoritätsladungsträgern. Mit anderen Worten, diese Kantenlänge bestimmt die Stromverstärkung des lateralen Transistors in Vorwärts- und Rückwärtsrichtung.

Bei Verwendung der $I^2L$-Grundschaltung in nach Art eines Flipflops aufgebauten Speicherzellen sind diese Stromverstärkungen unter Umständen zu gering, um betriebssichere Speicheranordnungen zu erhalten.

Dies äussert sich darin, dass das beim Abfühlen des Leitzustandes des invertierenden Transistors bei leitendem Transistor durch Rückinjektion von Ladungsträgern an der Injektionszone gelieferte Signal u. U. zu schwach ist, um ein eindeutiges Lesesignal feststellen zu können.

Hier will die Erfindung Abhilfe schaffen.

Die Erfindung, wie sie im Anspruch 1 gekennzeichnet ist, löst die Aufgabe, eine monolithisch integrierte Speicheranordnung mit in einer Matrix angeordneten, nach Art eines Flipflops jeweils aus zwei kreuzgekoppelten $I^2L$-Strukturen gebildeten Speicherzellen anzugeben, bei denen das Lesesignal von dem in die dem jeweils leitenden invertierenden Transistor zugeordneten Injektionszone rückinjizierten Ladungsträgerstrom abgeleitet wird, wobei trotz Auslegung der Strukturen auf minimalen Flächenbedarf ein ausreichendes Lesesignal gewährleistet wird.

Die Erfindung wird im folgenden anhand von lediglich einen Ausführungsweg darstellenden Zeichnungen näher erläutert.

Es zeigen:

Fig. 1A die Schnittansicht der Struktur der bekannten $I^2L$-Grundschaltung,

Fig. 1B das Schaltbild der Struktur gemäss Fig. 1A,

Fig. 2 das Blockschaltbild eines Ausschnitts einer Zeile der Matrix einer Speicheranordnung nach einem Ausführungsbeispiel der Erfindung,

Fig. 3 das Schaltbild zweier, in einer Zeile der Matrix benachbarter Speicherzellen der Speicheranordnung nach einem Ausführungsbeispiel der Erfindung,

Fig. 4A die Draufsicht eines zwei Speicherzellen einer Zeile umfassenden Ausschnitts der integrierten Struktur der Speicheranordnung nach einem Ausführungsbeispiel der Erfindung,

Fig. 4B die Schnittansicht in der Schnittlinie 4B-4B der Struktur nach Fig. 4A und

Fig. 4C die Schnittansicht in der Schnittlinie 4C-4C der Struktur nach Fig. 4A.

Die in Fig. 1A in Schnittansicht dargestellte Halbleiterstruktur ist die Grundstruktur der unter dem Begriff "Integrated Injection Logic" bekannten logischen Grundschaltung. Der grundsätzliche Aufbau sowie die Wirkungsweise dieser Struktur sind in der eingangs genannten Literatur ausführlich beschrieben, so dass hier lediglich eine zusammenfassende Darstellung gegeben wird. Die Bezugszeichen sind so gewählt, dass aus ihnen gleichzeitig der Leitungstyp zu ersehen ist.

Als Ausgangsmaterial dient ein schwach dotiertes Halbleitersubstrat $P^-$ eines ersten Leitungstyps, also beispielsweise des P-Leitungstyps. Auf dem Halbleitersubstrat befindet sich eine hochdotierte vergrabene Zone N1 + des entgegengesetzten Leitungstyps. Über der vergrabenen Zone N1 + ist eine N-dotierte, epitaktisch aufgebrachte Halbleiterschicht N1 angeordnet. In die Halbleiterschicht N1 sind in einem gewissen Abstand voneinander zwei zur Halbleiterschicht entgegengesetzt dotierte Zonen P1 und P2 eingebracht. In der Zone P2 befindet sich eine weitere, dazu entgegengesetzt dotierte Zone N2. Diese Struktur ist von einer abgesenkten dielektrischen Isolationszone IZ umgeben. Anstelle dieser dielektrischen Isolation ist auch eine Sperrschicht-Isolation möglich.

Das elektrische Schaltbild der bis hierher beschriebenen Struktur ist in Fig. 1B dargestellt, wobei durch die gleichartige Bezeichnung der einzelnen identischen Zonen ein direkter Vergleich zwischen Struktur und Schaltbild ermöglicht wird.

Demnach besteht die erfindungsgemäss verwendete Grundschaltung im wesentlichen aus einem invertierenden Transistor T1 mit den Zonenfolge N2, P2, N1, der durch direkte Injektion von Minoritätsla-

dungsträgern gespeist wird. Der invertierende Transistor T1 ist als invers betriebener vertikaler Transistor aufgebaut. Zum Zwecke der Injektion von Minoritätsladungsträgern ist ein dazu komplementären Transistor T2 der Zonenfolge P1, N1, P2 vorgesehen, der in der betrachteten Struktur lateral ausgebildet ist. Beide Transistoren sind in einer höchsten Integration erlaubenden Weise durch Zusammenlegen gemeisamer, auf gleichem Potential liegender Halbleiterzonen miteinander verschmolzen. Die Halbleiterschicht N1 dient gleichzeitig als Basiszone des lateralen Transistors T2 und als Emitterzone des vertikalen Transistors T1. Die Injektionszone P1 bildet die Emitterzone des Transistors T2. Die Zone P2 bildet gleichzeitig die Basiszone des vertikalen, invertierenden Transistors T1 und die Kollektorzone des injizierenden lateralen Transistors T2. Die Zone N2 bildet die Kollektorzone des invertierenden Transistors T1. An der die Emitterzone des injizierenden Transistors bildenden Zone P1 befindet sich ein Injektoranschluss I, über den extern ein Strom eingespeist wird. Dieser Strom liefert den Basisstrom für den invertierenden Transistor T1. An der die Basiszone dieses Transistors bildenden Zone P2 liegt ein Steueranschluss S, über den der Leitzustand des invertierenden Transistors T1 schaltbar ist. An der Zone N2 befindet sich der Kollektoranschluss O, der gleichzeitig den Ausgang der invertierenden Grundschaltung bildet. Der vom Steuersignal am Steueranschluss S bestimmte Leitzustand des invertierenden Transistors T1 lässt sich über einen Injektionsstrompfad, also durch eine in die Speisestromzuführung eingeschaltete, nicht dargestellte Abfühlschaltung abfühlen. Dabei wird davon Gebrauch gemacht, dass bei leitendem Transistor T1 die Basiszone P2 gleichzeitig eine Emitterwirkung aufweist und einen zum normalen Injektionsstrom bzw. Speisestrom entgegengesetzten Strom in die eigentliche Injektionszone P1 des lateralen Transistors T2 rückinjiziert. Der über den Injektionsanschluss I fliessende Strom weist somit bei leitendem invertierenden Transistor T1 einen geringeren Wert auf als bei gesperrtem Transistor (gleiches $V_{BE}$ vorausgesetzt). Dieser unterschiedliche Strom kann mit einer gebräuchlichen Abfühlschaltung abgefühlt werden. Die Tatsache der Rückinjektion bei leitendem Transistor T1 ist im Ersatzschaltbild durch die durch gestrichelte Linien zusätzlich zum normalen Transistor T2 eingezeichnete, parallele Transistorstruktur angedeutet, bei der also Kollektor und Emitter vertauscht sind. Die Abfühlschaltung kann dabei als Einrichtung ausgebildet werden, die entweder die Stromdifferenz oder eine entsprechende Spannungsdifferenz feststellt. Auf diese Weise erhält man also eine Abfühlmöglichkeit für den Leitzustand des invertierenden Transistors T1, ohne dass zusätzliche Leitungen oder Halbleiterzonen in der bereits vorhandenen Grundstruktur erforderlich wären.

Es sei die Fig. 2 näher betrachtet. Der hier schematisch dargestellten Zeile der Matrix einer Speicheranordnung nach der Erfindung ist das die Erfindung kennzeichnende wesentliche Merkmal zu entnehmen.

Die ausschnittsweise dargestellte Matrixzeile umfasst beispielsweise zwei Gruppen von Speicherzellen 1 bis m und 1' bis m'. Die Gruppeneinteilung ist so getroffen, dass bei einer Adressierung aus jeder Gruppe jeweils nur eine Speicherzelle selektiert wird.

Wie anschliessend noch ausführlich erläutert, handelt es sich bei diesen Speicherzellen um aus jeweils zwei zu einem Flipflop verbundenen $I^2L$-Strukturen, wie sie anhand der Fig. 1A und 1B beschrieben wurden. Jeder Speicherzelle ist ein Bitleitungspaar BL01, BL11 bis BL0m, BL1m bzw. BL01', BL11' bis BL0m', BL1m' zugeordnet. Jedes Bitleitungspaar definiert eine Spalte der Speichermatrix. Ausserdem ist für die Speicherzellen einer Zeile eine gemeinsame Adressleitung X vorgesehen. Über die Bitleitungen erfolgt die Zufuhr der Schreib/Lesesignale aus zugeordneten Schreib/Leseschaltungen R/W. Über die Adressleitung X, die an einen Leitungtreiber W angeschlossen ist, erfolgt die eigentliche Adressierung.

Das Problem, dass bei der betrachteten Speicherzellenart die von den in den Schreib/Leseschaltungen enthaltenen Differenzverstärkern an den Bitleitungspaaren abgefühlten Lesesignale relativ schwach sind, wird nun dadurch gelöst, dass die vorhandene gemeinsame Adressleitung X in zwei Teiladressleitungen X1 und X2 aufgespalten wird, die nach jeder der bereits definierten Gruppe von Speicherzellen über einen Widerstand RX an die gemeinsame Adressleitung X angeschlossen werden. Das Ergebnis dieser Massnahme der Adressleitungsaufteilung sei anhand der Fig. 3 erläutert. Dargestellt sind im Schaltbild zwei benachbarte Speicherzellen 1 und 2 einer durch die Adressleitung X definierten Matrixzeile.

Jede Speicherzelle umfasst, wie bereits ausgeführt, zwei $I^2L$-Grundschaltungen, wie sie in den Fig. 1A und 1B dargestellt sind. Die einzelnen Halbleiterzonen sind wiederum mit den gleichen Bezugszeichen versehen, wie in den Fig. 1A und 1B, wobei die Bezeichnungen der einen der beiden Grundschaltungen zur Unterscheidung mit einem Strichindex versehen wird. Die Speicherzelle ist also nach Art eines Flipflops aufgebaut. Die beiden invertierenden Transistoren T1 und T1' bilden die eigentlichen Flipflop-Transistoren. Dabei ist jeweils der Kollektor des invertierenden Transistors der einen Grundschaltung mit der Basis des invertierenden Transistors der anderen Grundschaltung verbunden. Auf diese Weise wird die erforderliche gegenseitige Rückkopplung der beiden invertierenden Grundschaltungen erzielt. Die Transistoren T2 und T2' der beiden Grundschaltungen bilden jeweils den injizierenden bzw. rückinjizierenden Transistor für den zugeordneten komplementären invertierenden Transistor T1 und T1'. Der Injektoranschluss I (s. Fig. 1A und 1B) jeder Grundschaltung ist mit einer zugeordneten Bitleitung BL0 bzw. BL1 eines entsprechenden Bitleitungspaares verbunden. Die Emitter der jeweils die eine Flipflophälfte bildenden invertierenden Transistoren T1 sind mit der ersten Teiladressleitung X1 und die Emitter der die jeweils zweite Flipflophälfte bildenden invertierenden Transistoren T1' sind mit der zweiten Teiladressleitung X2 verbunden. Die beiden Teiladressleitungen sind jeweils nach der bereits definierten Gruppe von Speicherzellen über jeweils einen Widerstand RX mit der gemeinsamen Adressleitung X verbunden.

Die Betriebsweise einer erfindungsgemässen Speicherzelle sei nun anhand der Fig. 3 näher betrachtet, wobei zunächst angenommen ist, es sei nur eine gemeinsame Adressleitung X vorgesehen, an die die Emitter sämtlicher invertierenden Transistoren T1 bzw. T1' einer Matrixzeile angeschlossen sind. Im Ruhezustand liegt die Adressleitung X beispielsweise auf einem Potential von 0,5 V. Die beiden zur betrachteten Speicherzelle führenden Bitleitungen BL0 und BL1 weisen gleiches Potential auf, das etwa 0,7 V höher ist als das der betrachteten Wortleitung X. Falls die Stromverstärkung der invertierenden Transistoren T1 und T1' in Emitterschaltung grösser als 1 ist, nimmt das Flipflop eine stabile Lage ein. Der Ruhestrom der Zelle kann dabei sehr klein gewählt werden.

Zum Adressieren der Speicherzelle wird das Potential der Adressleitung X um einige 100 mV abgesenkt, beispielsweise auf 0 V.

Eine Schreiboperation ist nunmehr ausserordentlich einfach durchzuführen. Nach dem Absenken des Potentials der Wortleitung X wird einer der beiden Bitleitungen ein Strom zugeführt. Soll beispielsweise der Flipflop-Transistor T1 der Zelle 1 in den leitenden Zustand gebracht werden, dann wird nur der Bitleitung BL0 der entsprechenden Matrixspalte ein Strom zugeführt. Ein grosser Teil dieses Stromes fliesst in die Basiszone des Flipflop-Transistors T1 und schaltet diesen Transistor ein. Damit ist der Speicherzustand der Speicherzelle festgelegt.

Eine Leseoperation besteht nun darin, dass neben dem Absenken des Potentials der Adressleitung X beiden betroffenen Bitleitungen dasselbe Potential eingeprägt wird. Dabei wird das Potential vorzugsweise so gewählt, dass die in die Speicherzelle fliessenden Ströme höher als im Ruhestand sind, um eine grössere Geschwindigkeit zu erzielen. Die am selben Bitleitungspaar liegenden nicht selektierten Speicherzellen werden dabei praktisch von der Stromversorgung abgeschaltet, da die Emitter-Basis-Spannung der entsprechenden lateralen Transistoren um einige 100 mV niedriger ist als die Emitter-Basis-Spannung der invertierenden Flipflop-Transistoren T1, T1' der selektierten Adressleitung X. Die Information der nicht selektierten Speicherzellen bleibt aber durch die gespeicherte Ladung in den Flipflop-Transistorkapazitäten für eine verglichen mit der Lesezeit lange Zeit erhalten. Nimmt man einen Speicherzustand der selektierten Zelle an, bei dem der Transistor T1 leitend und der Transistor T1' gesperrt ist, so wird in die Bitleitung BL0 aufgrund des Effektes der Rückinjektion ein Strom rückgespeist, nicht dagegen in die Bitleitung BL1. In die beiden Bitleitungen fliesst demnach ein unterschiedlicher Strom. Diese Stromdifferenz kann mit Hilfe einer Abfühlschaltung in Form eines niederohmigen Anzeigeverstärkers gemessen werden und liefert eine Aussage über den Speicherzustand der betrachteten Speicherzelle.

Die zweite Möglichkeit, eine Leseoperation durchzuführen, besteht darin, dass man anstelle eingeprägter Spannungen eingeprägte Ströme auf den Bitleitungen verwendet. An den Bitleitungen ist dann eine Spannungsdifferenz festzustellen, die sich mit Hilfe eines angeschlossenen Differenzverstärkers verstärken lässt und ein den Speicherzustand der Speicherzelle kennzeichnendes Signal liefert.

Eine derart betriebene Speicherzelle zeichnet sich durch hohe Dichte, extrem kleine Verlustleistung und gute Stabilität aus. Ein Nachteil ist das relativ kleine Lesesignal (etwa 15 bis 30 mV), das vor allem bei grossen Leseströmen wegen der abnehmenden Stromverstärkung auftritt. Dies führt zu hohen Anforderungen an die Schaltkreise, die nach der Leseoperation wieder für möglichst gleiche Bitleitungspotentiale sorgen müssen, und beeinträchtigt die Lesegeschwindigkeit und den Störabstand beim Lesen. Es ist also festzustellen, dass das Lesesignal der betrachteten Speicherzelle in Abhängigkeit vom Lesestrom abfällt. Das ohnehin schon knappe Lesesignal wird mit zunehmendem Lesestrom wesentlich kleiner, so dass für eine einwandfreie Leseoperation der Lesestrom auf relativ kleine Werte beschränkt werden muss. Um diesen nachteiligen Effekt zu eliminieren, wird erfindungsgemäss eine Aufspaltung der Adressleitung X in zwei partielle Teiladressleitungen X1 und X2 vorgeschlagen, die jeweils über einen Widerstand RX nach mehreren Zellen wieder an die gemeinsame Adressleitung X angeschlossen werden.

Betrachtet man nunmehr eine Leseoperation, so ergibt sich folgende Funktionsweise.

Angenommen wird, dass aus einer Gruppe m Zellen zwischen zwei Wortleitungsanschlüssen nur eine Speicherzelle zu einer bestimmten Zeit selektiert wird, d.h., mit Bitleitungsströmen IL gespeist wird. Dies ist im Beispiel von Fig. 3 die Speicherzelle 1. Der linke Flipflop-Transistor T1 sei dabei leitend, während der rechte Flipflop-Transistor T1' gesperrt ist. Unter dieser Voraussetzung besteht der Strom IX2 auf der Teiladressleitung X2 lediglich aus dem Basisstrom IB2' des nicht gesättigten lateralen Transistors T2' und ergibt sich zu

$$IX2 = IL \cdot (1 - \alpha N),$$

wobei N die Vorwärtsstromverstärkung des lateralen Transistors T2' in Basisschaltung angibt.

In der Teilwortleitung X1 fliesst die Differenz aus dem der Speicherzelle zugeführten Gesamtstrom (2IL) und dem Strom IX2 und ergibt sich zu

$$IX1 = 2 \cdot IL - IX2 = IL \cdot (1 + \alpha N).$$

Die beiden Ströme IX1 und IX2 auf den Teilwortleitungen X1 und X2 erzeugen damit zwischen den beiden Teilwortleitungen X1 und X2 eine Spannungsdifferenz von

$$\Delta VX = RX \cdot IL \cdot [(1 + \alpha N) - (1 - \alpha N)] = RX \cdot IL \cdot 2 \cdot \alpha N$$

Zwischen den beiden Bitleitungen BL0 und BL1 an der betrachteten selektierten Speicherzelle 1 ergibt sich eine Lesespannung von $\Delta VS = \Delta VSO + 2 \cdot RX \cdot IL \cdot \alpha N$, wobei $\Delta VSO$ das Lesesignal bei ungespaltener, gemeinsamer Wortleitung X angibt.

Man kann also durch geeignete Dimensionierung der Widerstände RX und der Bitleitungsströme IL das Lesesignal beträchtlich erhöhen. Es ist lediglich dafür zu sorgen, dass die Spannungsdifferenz $\triangle$VX zwischen den beiden Teilwortleitungen X1 und X2 stets kleiner ist als die Spannungsdifferenz zwischen den beiden Kreuzkopplungspunkten. Diese Spannung liegt in der Grössenordnung von 700 mV.

Man kann also das Lesesignal auf einige 100 mV erhöhen. Dadurch werden die geschilderten Probleme der Speicheranordnung eliminiert. Für einen gewünschten Lesestrom (Bitleitungsstrom) IL = 200 uA z.B. und einem $\triangle$VX = 200 mV ergibt sich ein Widerstandswert RX von etwa 1 bis 2 k$\pi$ (abhängig vom Wert $\alpha$, N). Für die gleichmässige Verteilung des Ruhestromes der Speicherzellen ist dieser Wert klein genug, so dass auch beim ungünstigsten Bitmuster die Ruhestromversorgung nicht beeinträchtigt wird. Für beispielsweise 16 Zellen mit je 100 nA Injektorruhestrom ergibt sich lediglich eine Spannungsdifferenz von $\triangle$ VX < 16.0,1$\mu$ A.1k$\pi$ = 1,6 mV zwischen den beiden Injektoren P1 und P1'.

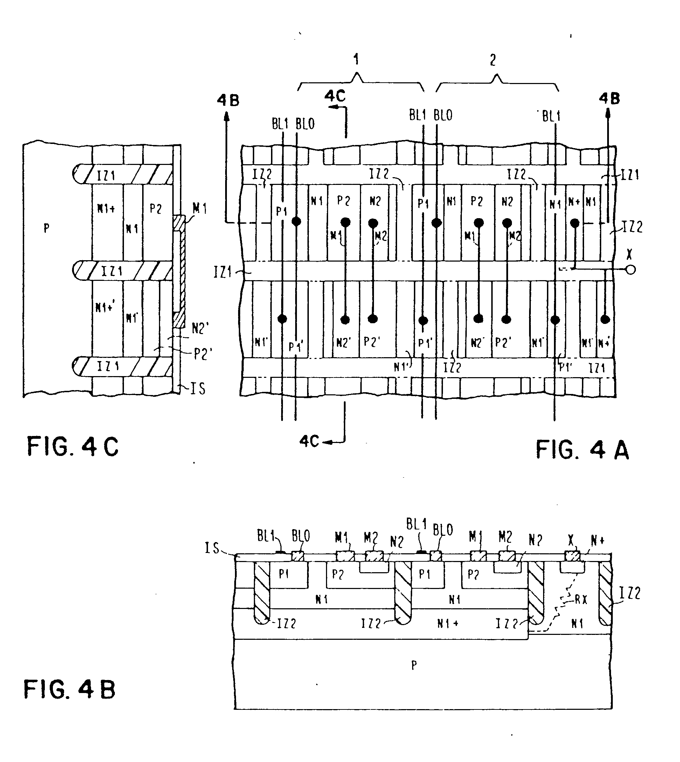

Ein Ausführungsbeispiel der monolithischen Auslegung einer erfindungsgemässen Speicheranordnung ist wiederum in einem zwei benachbarte Speicherzellen eine Matrixzeile umfassenden Ausschnitt der Speichermatrix in Fig. 4A in Draufsicht und in den Fig. 4B und 4C in Schnittansichten dargestellt. Dieser Ausschnitt umfasst also die beiden in Fig. 3 im Ersatzschaltbild dargestellten Speicherzellen. Auch hier sind wiederum für die einzelnen Halbleiterzonen übereinstimmende Bezugszeichen verwendet, die in einfacher Weise die Verbindung zwischen der in den Fig. 1A und 1B dargestellten I²L-Grundstruktur, dem in Fig. 3 im Ersatzschaltbild dargestellten, zwei Speicherzellen umfassenden Ausschnitt und der in den Fig. 4 dargestellten integrierten Struktur ermöglichen. Demzufolge setzt sich jede Speicherzelle aus zwei der in den Fig. 1A und 1B dargestellten I²L-Grundstrukturen zusammen. Die beiden eine Speicherzelle bildenden Grundstrukturen sind jeweils durch eine Isolationszone IZ1 voneinander getrennt. Der monolithische Aufbau besteht nun darin, dass auf ein Halbleitersubstrat P⁻ eine Epitaxieschicht N1 aufgebracht ist. Diese Epitaxieschicht N1 ist durch die in Zeilenrichtung verlaufenden Isolationszonen IZ1 streifenförmig unterteilt. Eine Zeile der Matrix umfasst demnach zwei derartige streifenförmige Gebiete N1 und N1', die durch eine Isolationszone IZ1 voneinander isoliert sind. Bei diesen Isolationszonen handelt es sich vorzugsweise um dielektrische Zonen, die bis in das Substrat P⁻ reichen, es können jedoch auch tiefe P-Zonen vorgesehen werden. In jedem der beiden Gebiete N1 und N1' ist eine durchgehende, in Zeilenrichtung verlaufende vergrabene Zone N1 + bzw. N1 + ' angeordnet, die der einen Zellhälfte sämtlicher Speicherzellen einer Matrixzeile gemeinsam ist. Diese vergrabenen, hochleitenden Zonen N1 + bzw. N1 + ' bilden die beiden Teiladressleitungen X1 und X2, die für die Speicherzellen jeder Matrixzeile vorgesehen sind. Die jeweils eine Speicherzelle bildenden beiden I²L-Grundstrukturen sind in Spaltenrichtung untereinander angeordnet und umfassen wie in den Fig. 1A und 1B bzw. in Fig. 3 angegeben, wiederum jeweils zwei lateral zueinander in der Epitaxieschicht N1 (N1') angeordnete Zonen P1 (P1') und P2 (P2') und eine weitere Zone N2 (N2') innerhalb der Zone P2 (P2'). Man erhält auf diese Weise die Speicherzelle mit vertikalen Transistoren T1 und T1' mit den Zonenfolgen N2P2N1 bzw. N2'P2'N1' und zugeordneten lateralen, die Injektion bewirkenden Transistoren T2 und T2' mit den Zonenfolgen P1N1P2 bzw. P1'N1'P2'. Im gezeigten Ausführungsbeispiel sind die Zellhälften vorzugsweise so gegeneinander verschoben angeordnet, dass die zwischen den Zonen P2 und N2' bzw. P2' und N2 vorzusehenden, die Kreuzkopplung bildenden Leiterzüge M1 und M2 jeweils parallel und in Spaltenrichtung verlaufen und somit eine minimale Länge aufweisen. Ausserdem ist für jede Spalte der Matrix ein Bitleitungspaar BL0, BL1 vorgesehen, das jeweils mit den zugeordneten Zonen P1 bzw. P1' der injizierenden Transistoren T2 bzw. T2' aller in einer Spalte der Matrix angeordneten Speicherzellen verbunden ist. Benachbarte Speicherzellen einer Matrixzeile sind ebenfalls durch eine dielektrische Isolationszone IZ2, die jeweils senkrecht zu den Isolationszonen IZ1 verlaufen und in diese übergehen, voneinander getrennt. Diese Isolationszonen IZ2 reichen im Gegensatz zu den Isolationszonen IZ1 nicht bis in das Substrat P sondern erstrecken sich nur geringfügig in die hochdotierten, die Teilwortleitungen X1 und X2 bildenden Zonen N1 + und N1' +, die für sämtliche Speicherzellen einer Matrixzeile durchgehend sein müssen. Die Isolationszone IZ2 verhindert parasitäre Kopplungen zwischen den Zellkomponenten zweier benachbarter Speicherzellen einer Matrixzeile. Die Bitleitungen BL0 und BL1 sowie die die Kreuzkopplung bewirkenden Leiterzüge M1 und M2 sind auf einer die gesamte Oberfläche der Anordnung bedeckenden Isolationsschicht IS angeordnet. Die Leiterzüge sind über in dieser Isolationsschicht IS angeordnete Kontaktlöcher mit den zugehörigen Halbleiterzonen verbunden.

Die erfindungsgemäss vorzusehenden Widerstände RX, die jeweils nach einer Gruppe von Speicherzellen die gemeinsame Wortleitung X mit den Teilwortleitungen X1 und X2 verbinden, lassen sich, wie die Fig. 4A und 4B jeweils am rechten Rande zeigen, sehr einfach durch geeignete Unterbrechung der vergrabenen Zone N1 + bzw. N1' + realisieren. Der dabei zwischen zwei Isolationszonen IZ2 eingegrenzte Bereich der Epitaxieschicht N1 bzw. N1' bildet als Schichtwiderstand die genannten Widerstände RX. Den einen Anschluss dieser Widerstände bildet das jeweilige Ende der hochdotierten Zonen N1 + bzw. N1 + ' während das andere Ende durch eine in die Zone N1 bzw. N1' eingebrachte hochdotierte Anschlusszone N + bzw. N1' + gebildet wird. Die gemeinsame Adressleitung X ist in den Fig. 4A und 4B nur angedeutet, sie wird vorzugsweise in einer zweiten Metallisierungsebene angeordnet und besteht aus einem Leiterzug pro Matrixzeile. Der Anschluss der Teiladressleitungen X1 und X2 an die Adressleitung X erfolgt über einen an den Anschlusszonen N + bzw. N1' + geführten Kontakt.

Zusammenfassend weist die Erfindung folgende Vorteile auf: Durch die Aufspaltung der Adressleitung erhält man ein sehr grosses Lesesignal, was zur Folge hat, dass die Anforderungen an den Leseverstärker verringert werden und dass eine erhöhte Lesegeschwindigkeit und ein grösserer Störabstand gegenüber parasitären Leseströmen der nichtselektierten Speicherzellen gewährleistet wird.

**Patentansprüche**

1. Monolithisch integrierte Speicheranordnung mit in einer Matrix angeordneten Speicherzellen aus jeweils zwei, jeweils einen Injektor (P1, P1') und zugeordneten invertierenden Transistor (T1, T1') umfassenden I$^2$L-Strukturen, die durch eine Kreuzkopplung zwischen jeweils dem Kollektor (N2 bzw. N2') des einen und der Basis (P2' bzw. P2) des anderen invertierenden Transistors zu einem Flipflop verbunden sind, wobei die Zufuhr des Betriebsstromes und der Schreib-/Leseströme der Speicherzelle einer Matrixspalte über ein an die Injektoren (P1, P1') dieser Speicherzellen angeschlossenes Bitleitungspaar (BLO, BL1) und die Selektion der Speicherzellen einer Matrixzeile über eine mit den invertierenden Transistoren (T1, T1') dieser Speicherzellen gekoppelte, gemeinsame Adressleitung (X) erfolgt, dadurch gekennzeichnet, dass die Emitter (N1) der invertierenden Transistoren (T1) der jeweils einen I$^2$L-Struktur der Speicherzellen jeder Matrixzeile an eine erste Teiladressleitung (X1) und die Emitter (N1') der invertierenden Transistoren (T1') der jeweils anderen I$^2$L-Struktur an eine zweite Teiladressleitung (X2) angeschlossen sind und dass jede der beiden Teiladressleitungen (X1, X2) jeweils nach einer Gruppe von Speicherzellen (1 bis m) über einen Widerstand (RX) mit der gemeinsamen Adressleitung (X) verbunden ist.

2. Monolithisch integrierte Speicheranordnung nach Anspruch 1, dadurch gekennzeichnet, dass jede I$^2$L-Struktur als invertierenden Transistor (T1, T1') die invers betriebene, vertikale Transistorstruktur und die Injektionszone (P1, P1') bzw. Emitterzone des zum invertierenden Transistor komplementären Transistors (T2, T2') umfasst, dessen Kollektor gleichzeitig die Basis (P2, P2') und dessen Basis gleichzeitig den Emitter (N1, N1') des invertierenden Transistors (T1, T1') bildet.

3. Monolithisch integrierte Speicheranordnung nach Anspruch 2, dadurch gekennzeichnet, dass eine auf ein Substrat (P—) eines ersten Leitungstyps aufgebrachte Halbleiterschicht des entgegengesetzten zweiten Leitungstyps durch in Zeilenrichtung verlaufende erste Isolationszonen (IZ1) je Matrixzeile in parallele Streifen (N1, N1') unterteilt ist, die jeweils die Emitter der invertierenden Transistoren (T1, T1') bzw. die Basen der komplementären Transistoren (T2, T2') der sich entsprechenden Zellhälften der Speicherzellen der jeweiligen Matrixzeile bilden, dass die Teiladressleitungen (X1, X2) aus längs der parallelen Streifen (N1, N1') verlaufenden, vergrabenen hochdotierten Zonen (N1+ bzw. N1'+) bestehen und dass die gemeinsame Adressleitung (X) aus jeweils einem zusätzlichen Leiterzug je Matrixzeile gebildet wird.

4. Monolithisch integrierte Speicheranordnung nach Anspruch 3, dadurch gekennzeichnet, dass die in einer Matrixzeile benachbarten I$^2$L-Strukturen durch in Spaltenrichtung verlaufende zweite Isolationszonen (IZ2), die die zugehörigen vergrabenen hochdotierten Zonen (N1+, N1'+) nicht völlig unterbrechen, voneinander getrennt sind.

5. Monolithisch integrierte Speicheranordnung nach Anspruch 3 oder 4, dadurch gekennzeichnet, dass die die Teiladressleitungen (X1, X2) bildenden; vergrabenen hochdotierten Zonen (N1+, N1'+) jeweils nach einer Gruppe von Speicherzellen unterbrochen sind, so dass der Schichtwiderstand des jeweils zwischen zwei benachbarten Isolationszonen (IZ2) der zweiten Art liegenden Bereiches der Halbleiterschicht (N1, N1') einen die jeweilige Teiladressleitung (X1, X2) mit der gemeinsamen Adressleitung (X) verbindenden Widerstand (RX) bildet.

6. Monolithisch integrierte Speicheranordnung nach Anspruch 5, dadurch gekennzeichnet, dass der eine Anschluss des Widerstandes (RX) durch das durch die Unterbrechung gebildete Ende der vergrabenen, hochdotierten Zone (N1+, N1'+) und dass der andere Anschluss durch eine in den Bereich der den Schichtwiderstand bildenden Halbleiterschicht (N1, N1') eingebrachte, mit der gemeinsamen Adressleitung (X) verbundene, hochdotierte Zone (N+) gebildet wird.

**Claims**

1. Monolithically integrated storage arrangement with storage cells arranged in a matrix, which comprise two I$^2$L structures each made up of an injector (P1, P1') and an associated inverting transistor (T1, T1') and connected in the form of a flip-flop by a cross-coupling between the collector (N2 and N2', respectively) of one transistor and the base (P2' and P2, respectively) of the other inverting transistor, wherein the operating current and the read/write currents of the storage cells of a matrix column are applied through a bit line pair (BLO, BL1) connected to the injectors (P1, P1') of these storage cells, and the selection of the storage cells of a matrix line is effected through a common address line (X) coupled to the inverting transistors (T1, T1') of these storage cells, characterized in that the emitters (N1) of the inverting transistors (T1) of one I$^2$L structure of the storage cells of each matrix line are connected to a first partial address line (X1) and the emitters (N1') of the inverting transistors (T1') of the other I$^2$L structure are connected to a second partial address line (X2), and that each of the two partial address lines (X1, X2) subsequent to each group of storage cells (1 to m) is connected to the common address line (X) through a resistor (RX).

2. Monolithically integrated storage arrangement according to claim 1, characterized in that each I$^2$L structure comprises as an inverting transistor (T1, T1') the inversely operated vertical transistor structure and the injection zone (P1, P1') and the emitter zone, respectively, of the transistor (T2, T2') complementary to the inverting transistor, the collector of transistor (T2, T2') simultaneously forming the base (P2, P2') and its base simultaneously forming the emitter (N1, N1') of the inverting transistor (T1, T1').

3. Monolithically integrated storage arrangement according to claim 2, characterized in that a semiconductor layer of the opposite second conductivity type applied to a substrate (P—) of a first conductivity type is subdivided into parallel stripes (N1, N1') by first isolation zones (IZ1) extending in line direction in each matrix line, said stripes respectively forming the emitters of the inverting transistors (T1, T1') and the bases of the complementary transistors (T2, T2') of the corresponding cell halves of the storage cells of the respective matrix line, that the partial address lines (X1, X2) are made up of buried highly doped zones (N1 + and N1' +, respectively) extending alongside the parallel stripes (N1, N1'), and that the common address line (X) is formed by one additional conductor for each matrix line.

4. Monolithically integrated storage arrangement according to claim 3, characterized in that the adjacent I²L structures in a matrix line are separated from each other by second isolation zones (IZ2) extending in column direction and not fully interrupting the appertaining buried highly doped zones (N1 +, N1' +).

5. Monolithically integrated storage arrangement according to claim 3 or 4, characterized in that the buried highly doped zones (N1 +, N1' +) forming the partial address lines (X1, X2) are interrupted subsequent to each group of storage cells, so that the sheet resistor of the region of the semiconductor layer (N1, N1') arranged between two adjacent isolation zones (IZ2) of the second type forms a resistor (RX) connecting the respective partial address line (X1, X2) to the common address line (X).

6. Monolithically integrated storage arrangement according to claim 5, characterized in that one terminal of the resistor (RX) is formed by the end of the buried highly doped zone (N1 +, N1' +) obtained by interruption, and that the other terminal is formed by a hyghly doped zone (N +) which is embedded in the region of the semiconductor layer (N1, N1') forming the sheet resistor, and which is connected to the common address line (X).

**Revendications**

1. Agencement de mémoire monolithique intégré à cellules d'emmagasinage disposées en matrice, qui comprennent deux structures I²L, chacune formée d'un injecteur (P1, P1')et d'un transistor inverseur associé (T1, T1') et connectée sous la forme d'une bascule par un couplage croisé entre le collecteur (N2 et N2', respectivement) d'un transistor et la base (P2' et P2, respectivement) de l'autre transistor inverseur, dans lequel le courant de fonctionnement et les courants de lecture/écriture des cellules d'emmagasinage d'une colonne de matrice sont appliqués au travers d'une paire de lignes de bits (BLO, BL1) connectées aux injecteurs (P1, P1') de ces cellules d'emmagasinage, et la sélection des cellules d'emmagasinage d'une ligne de matrice est effectuée au travers d'une ligne d'adresse commune (X) couplée aux transistors inverseurs (T1, T1') de ces cellules d'emmagasinage, caractérisé en ce que les émetteurs (N1) des transistors inverseurs (T1) d'une structure I²L des cellules d'emmagasinage de chaque ligne de matrice sont connectés à une première ligne d'adresse partielle (X1) et les émetteurs (N1')

des transistors inverseurs (T1') de l'autre structure I²L sont connectés à une deuxième ligne d'adresse partielle (X2), et en ce que chacune des deux lignes d'adresse partielle (X1, X2) attachée à chaque groupe de cellules d'emmagasinage (1 à m) est connectée à la ligne d'adresse commune (X) au travers d'une résistance (RX).

2. Agencement de mémoire monolithique intégré selon la revendication 1 caractérisé en ce que chaque structure I²L comporte, en tant que transistor inverseur (T1, T1'), la structure à transistor vertical actionné inversement et en ce que respectivement la zone d'injection (P1, P1') et la zone d'émission, du transistor (T2, T2') complémentaire du transistor inverseur, le collecteur du transistor (T2, T2') servant également de base (P2, P2') du transistor (T1, T1'), et sa base servant également d'émetteur (N1, N1') du transistor inverseur (T1, T1').

3. Agencement de mémoire monolithique intégré selon la revendication 2, caractérisé en ce qu'une couche semiconductrice du second type de conductivité opposée appliquée à un substrat (P—) d'un premier type de conductivité, est subdivisée en bandes parallèles (N1, N1') par des premières zones d'isolation (IZ1) s'étendant dans la direction de chaque ligne de matrice, lesdites bandes formant respectivement les émetteurs des transistors inverseurs (T1, T1') et les bases des transistors complémentaires (T2, T2') des moitiés de cellules correspondantes des cellules d'emmagasinage de la ligne de matrice respective, en ce que les lignes d'adresse partielle (X1, X2) sont constituées de zones hautement dopées enterrées (N1 + et N1' +, respectivement) s'étendant le long des bandes parallèles (N1, N1'), et en ce que la ligne d'adresse commune (X) est formée par un cunducteur supplémentaire pour chaque ligne de matrice.

4. Agencement de mémoire monolithique intégré selon la revendication 3, caractérisé en ce que les structures I²L adjacentes d'une ligne de matrice sont séparées les unes des autres par des deuxièmes zones d'isolation (IZ2) s'étendant dans la direction des colonnes et n'interrompant pas complétement les zones hautement dopées enterrées correspondantes (N1 +, N1' +).

5. Agencement de mémoire monolithique intégré selon la revendication 3 ou 4, caractérisé en ce que les zones hautement dopées enterrées (N1 +, N1' +) formant les lignes d'adresse partielle (X1, X2) sont interrompues après chaque groupe de cellules de mémoire, de façon que la résistance de feuille de la région de la couche semi-conductrice (N1, N1') disposée entre deux zones d'isolation adjacentes (IZ2) du deuxième type, forme une résistance (RX) connectant la ligne d'adresse partielle respective (X1, X2) à la ligne d'adresse commune (X).

6. Agencement de mémoire monolithique intégré selon la revendication 5, caractérisé en ce qu'une borne de la résistance (RX) est formée par l'extrémité de la zone hautement dopée enterrée (N1 +, N1' +) et en ce que l'autre borne est formée par une zone hautement dopée (N +) qui est noyée dans la région de la couche semi-conductrice (N1, N1') formant la résistance de feuille, et qui est connectée à la ligne d'adresse commune (X).

FIG. 1A                                    FIG.1B

FIG. 2

FIG. 3

FIG. 4 C

FIG. 4 A

FIG. 4 B